# EUROPEAN PATENT APPLICATION

(11) **EP 4 489 072 A1**
(43) Date of publication of application: **08.01.2025**
(21) Application number: 24186003.0
(22) Date of filing: 02.07.2024
(51) Int. Cl.: H01L 23/498, H01L 25/065, H01L 25/18

(54) **SEMICONDUCTOR DEVICE INCLUDING INTERCONNECT PACKAGE WITH CAPACITOR EMBEDDED THEREIN**

(30) Priority: 03.07.2023 US 202363524747 P; 03.04.2024 US 202418625690
(71) Applicant: Samsung Electronics Co., Ltd., Suwon-si, Gyeonggi-do 16677 (KR)
(72) Inventor: YANG, Jin, San Jose, CA, 95134 (US)
(74) Representative: Kuhnen & Wacker Patent- und Rechtsanwaltsbüro PartG mbB

(57) **Abstract**

Provided is a semiconductor package which includes: a die stack including at least two semiconductor chips laterally arranged and isolated from each other by a molding material; and an interconnect package disposed above or below the die stack and connecting the semiconductor chips to each other, wherein the interconnect package having a smaller lateral width than the die stack is entirely overlapped by the die stack in a vertical direction, and a capacitor is disposed inside the interconnect package and connected to at least one of the semiconductor chips and configured to be connected to a voltage source and a ground.

## Description

### BACKGROUND

### 1. Field

Apparatuses and methods related to a semiconductor device including an interconnect package in which a capacitor is embedded.

### 2. Description of Related Art

Semiconductor packaging technology has been rapidly developed to address the demands for high device density and performance for an integrated circuit. In multi-chip semiconductor packaging, technical challenges lie ahead in designing an interconnect structure connecting semiconductor chips in a semiconductor package considering impedance and noise that adversely affect performance of a semiconductor device including the semiconductor chips.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The invention is set out in the appended claims.

The disclosure provides a semiconductor package including at least one interconnect package in which at least one capacitor is disposed and connected to semiconductor chips, where the interconnect package is stacked above a package substrate with a redistribution substrate therebetween. The redistribution substrate may include a plurality of wiring traces connecting the semiconductor chips to another circuit element in the package substrate or outside the package substrate. The interconnect package may be included in the redistribution substrate. The semiconductor package may be a fan-out wafer level package (FOWLP). The capacitor may be a decoupling capacitor configured to reduce impedance and noise applied to a load, that is, the semiconductor chips in the semiconductor package.

While the decoupling capacitor is generally implemented by a die side capacitor (DSC) or a land side capacitor (LSC) disposed on a top surface or a bottom surface of the package substrate, respectively, the semiconductor package according to embodiments may include at least one capacitor in the interconnect package provided to locally connect the semiconductor chips to each other in a small footprint. Thus, at least one of the DSC and the LSC may be removed from the semiconductor package because the capacitor in the interconnect package may replace the removed DSC or LSC as a decoupling capacitor. This capacitor included in the interconnect package may be referred to as an integrated stack capacitor (ISC) which has a thickness of a few micrometers or less and a very high capacitance density.

The interconnect package may include at least one redistribution layer in which a plurality of dielectric layers and wiring traces are formed, and the capacitor may be formed on at least one of the wiring traces.

In the interconnect package, the redistribution layer may be formed at an upper portion of the interconnect package, and the capacitor may be formed at an upper portion of the redistribution layer so that the capacitor can be disposed close to the semiconductor chips for a better decoupling performance.

With this capacitor embedded in the redistribution layer in the interconnect package, the semiconductor package may achieve power delivery to the semiconductor chip with low impedance and noise, and a smaller footprint in a semiconductor device including the semiconductor package.

### BRIEF DESCRIPTION OF DRAWINGS

Example embodiments of the inventive concept will be more clearly understood from the following detailed description taken in conjunction with the accompanying drawings in which:
FIG. 1A illustrates a schematic cross-section view of semiconductor package including interconnect packages and decoupling capacitors, according to an embodiment;
FIG. 1B illustrates a schematic cross-section view of a interconnect package included in the semiconductor package shown in FIG. 1A, according to an embodiment;
FIG. 2A illustrates a schematic cross-section view of semiconductor package including interconnect packages and decoupling capacitors, according to another embodiment, and FIG. 2B illustrates a schematic cross-section view of an interconnect package included in the semiconductor package shown in FIG. 2A, according to an embodiment;
FIG. 3A illustrates a schematic cross-section view of semiconductor package including interconnect packages and decoupling capacitors, according to still another embodiment, and FIG. 3B illustrates a schematic cross-section view of an interconnect package included in the semiconductor package shown in FIG. 3A, according to an embodiment;
FIG. 4 illustrates a flowchart for a method of manufacturing a semiconductor package including an interconnect package and a decoupling capacitor therein, according to embodiments;
FIGS. 5A-5F illustrate intermediate semiconductor packages after respective steps of manufacturing a semiconductor package including an interconnect package and a decoupling capacitor therein based on the flowchart shown in FIG. 4, according to embodiments;

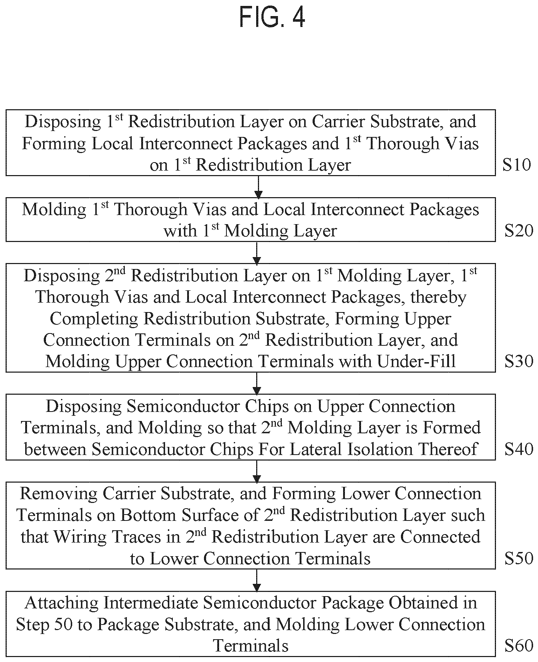

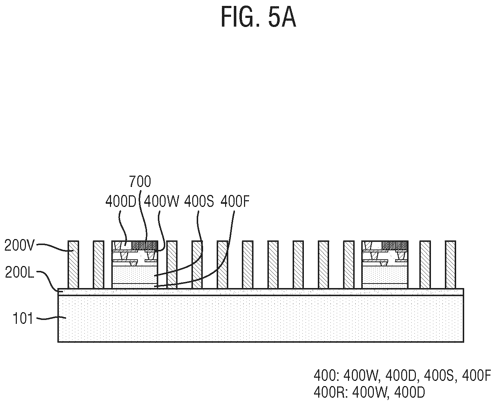

FIG. 5A illustrates an intermediate semiconductor package after step 10 shown in FIG. 4, according to embodiments

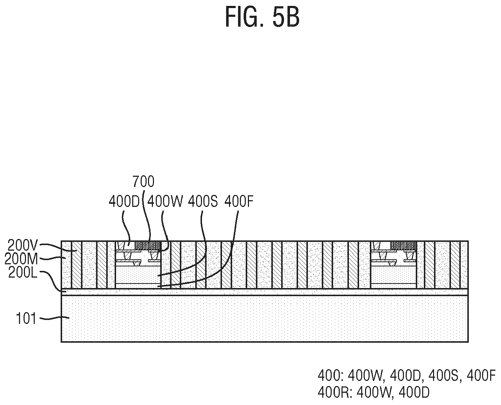

FIG. 5B illustrates an intermediate semiconductor package after step 20 shown in FIG. 4, according to embodiments;

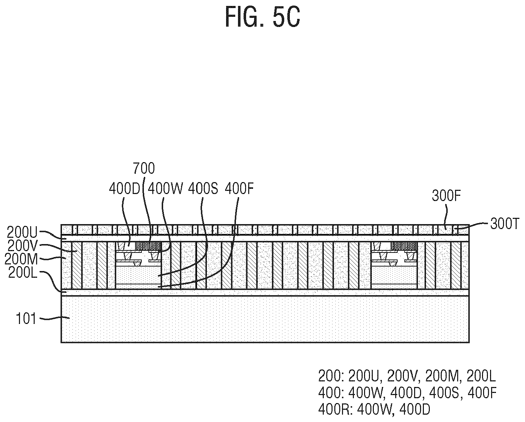

FIG. 5C illustrates an intermediate semiconductor package after step 30 shown in FIG. 4, according to embodiments;

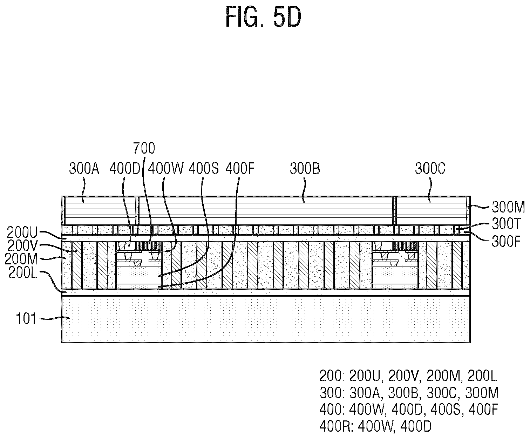

FIG. 5D illustrates an intermediate semiconductor package after step 40 shown in FIG. 4, according to embodiments;

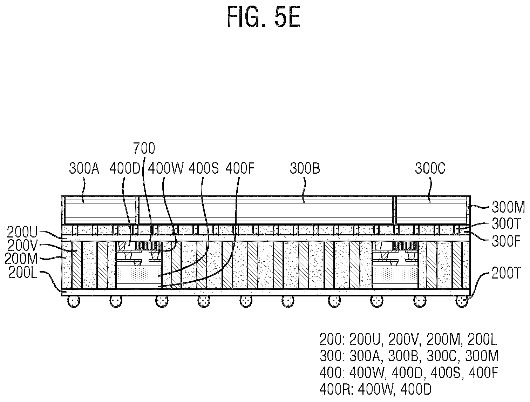

FIG. 5E illustrates an intermediate semiconductor package after step 50 shown in FIG. 4, according to embodiments;

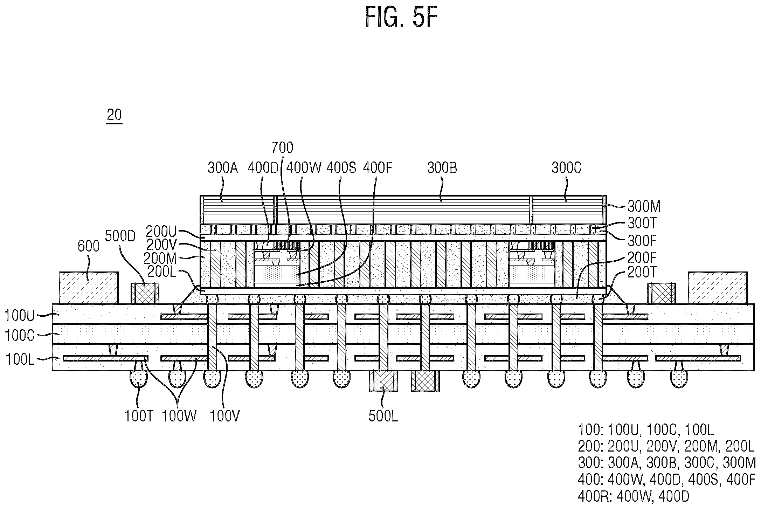

FIG. 5F illustrates an intermediate semiconductor package after step 60 shown in FIG. 4, according to embodiments; and

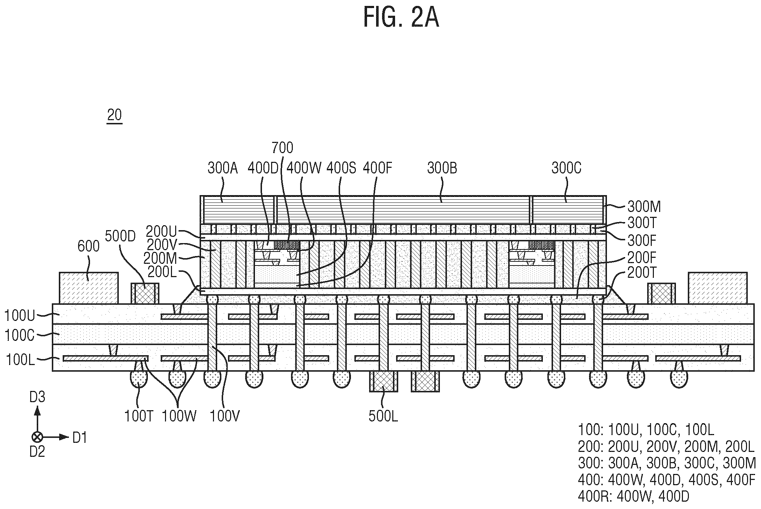

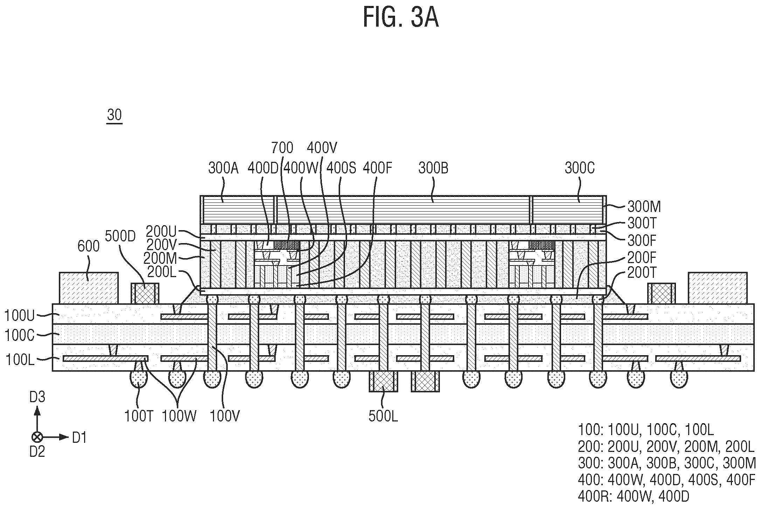

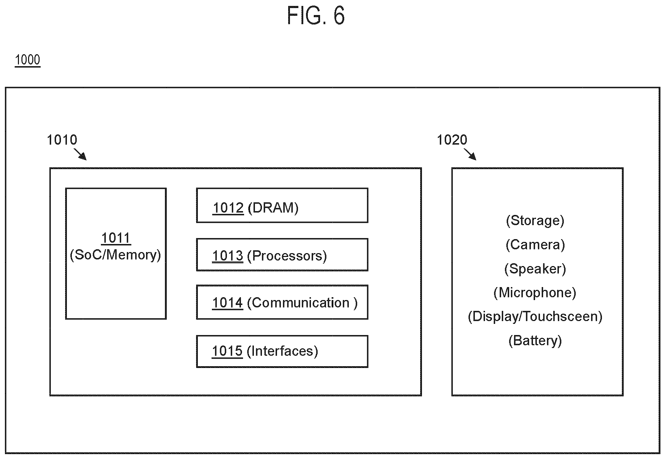

FIG. 6 is a schematic block diagram illustrating an electronic device including at least one of semiconductor packages shown in FIGS. 2A-2B and/or 3A-3B, according to an example embodiment.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," or "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "first" element or a "second" element, respectively, as long as their structural relationship is clearly understood in the context of the descriptions. Similarly, the terms a "lower" element and an "upper" element may be respectively referred to as a "first" element and a "second" element with necessary descriptions to distinguish the two elements.

It will be understood that, although the terms "first," "second," "third," "fourth," "fifth," "sixth," etc. may be used herein to describe various elements, these elements should not be limited by these terms. These terms are only used to distinguish one element from another element. Thus, a first element discussed below could be termed a second element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension.

It will be also understood that, when a method of manufacturing an apparatus or structure is described as including a plurality of steps or operations, a certain step or operation described as being be performed later than another step or operation may be performed prior to or at the same time as the other step or operation unless the other step or operation is described as being performed prior to the step or operation. Further, the method may include additional steps or operations not mentioned in the description.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers included in a semiconductor package including a connection pad, an adhesive layer, an isolation layer, a barrier metal pattern, a seed layer, etc. may or may not be described in detail herein. For example, certain connection pads of a semiconductor chip connected to solder balls or bumps in a semiconductor package may be omitted herein when these structural element is not related to the novel features of the embodiments. Also, descriptions of materials forming well-known structural elements may be omitted herein when those materials are not relevant to the novel features of the embodiments. Herein, the term "connection" between two structures or elements may refer to electrical connection therebetween. For example, connection between semiconductor chips, semiconductor packages, and/or semiconductor devices may refer to electrical connection of corresponding two or more elements to each other. The terms "coupled" and "connected" may have the same meaning and used interchangeably herein. Further, the term "isolation" between two structures or elements pertains to electrical insulation or separation therebetween. For example, isolation of wiring patterns from each other may mean that the wiring patterns are not electrically connected to each other.

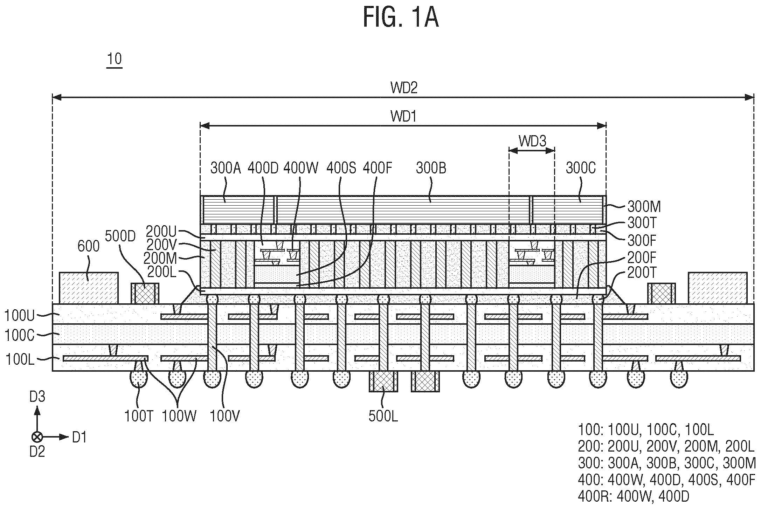

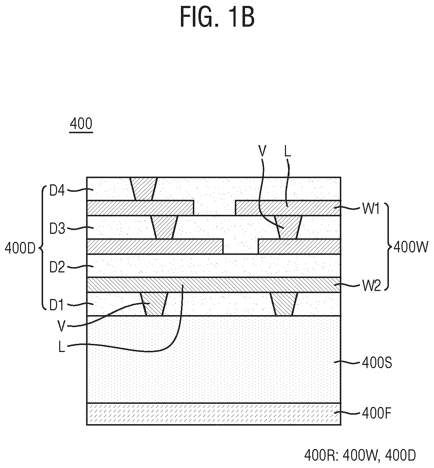

Herebelow, various embodiments of the disclosure are described with reference to FIGS. 1-6.

High-performance semiconductor chips such as a central processing unit (CPU), a graphic processing unit (GPU), an artificial intelligence (AI) chip, etc. consume a greater amount of power, compared to other types of semiconductor chip such as a memory chip. For example, power consumption by these high-performance chips may reach a very high level (e.g., around 1000 W) for a thermal design power (TDP). The greater power consumption imposes challenges to designing a power delivery network (PDN) for the high-performance chips, and thus, there is an increased need to design a PDN with a low impedance across multiple frequency ranges when a semiconductor package including the high-performance chips is designed and manufactured.

The evolution of packaging multiple high-performance semiconductor chips has introduced a plurality of different die-to-die interconnect structures such as a silicon interposer of which a size grows to 3 or 4 times of a reticle size up to 3,000 mm². The silicon interposer may include a redistribution layer (RDL) in which a plurality of wiring patterns or traces are formed in one or more dielectric layers to connect semiconductor chips in a semiconductor package to each other. Accordingly, the power delivery risk in the multi-chip package including the interconnect structure has also become a consideration factor in designing the semiconductor package. Further, when the interconnect structure includes active devices such as transistors and metal layers therein, power consumption increases under a certain switching frequency for the active devices. Thus, there is a demand for mitigating the power delivery risk, or reduce an impedance applied to the multi-chip package in which the interconnect structure connects the semiconductor chips to each other.

Decoupling capacitors are included in a semiconductor package to control impedance and remove noise in a power delivery path to a semiconductor chip in the semiconductor package. As a decoupling capacitor, a semiconductor package of the related art includes one or more capacitors such as a multilayer ceramic capacitor (MLCC), a metal-in-metal (MiM) capacitor, a deep trench capacitor (DTC), etc. How to configure one or more decoupling capacitors in a semiconductor package may affect power-delivery performance of a semiconductor device including the semiconductor package of various high-power requiring semiconductor chips.

FIG. 1A illustrates a schematic cross-section view of semiconductor package including interconnect packages and decoupling capacitors, according to an embodiment, and FIG. 1B illustrates a schematic cross-section view of an interconnect package included in the semiconductor package shown in FIG. 1A, according to an embodiment.

Referring to FIG. 1A, a semiconductor package 10 may include a package substrate 100, a redistribution substrate 200 disposed thereabove, and a die stack 300 disposed above the redistribution substrate 200 with a plurality of connection structures therebetween, according to an embodiment. The die stack 300 may include a plurality of semiconductor chips 300A-300C laterally arranged and isolated from each other, and the redistribution substrate 200 may include a interconnect package 400 therein.

The semiconductor package 10 may be a fan-out wafer level package (FOWLP) which may be characterized by one or more redistribution layers connecting semiconductor chips or dies to a package substrate. The FOWLP allows for a smaller package size and improved electrical performance compared to other types of semiconductor package such as a fan-in package, a wire-bond package, etc. In the FOWLP, a lateral edge of the package profile may be extended in a D1 direction beyond a lateral edge of the semiconductor chips 300A-300C included therein as shown in FIG. 1A. A lateral width WD1 of each of the die stack 300 and the redistribution substrate 200 may be smaller than a lateral width WD2 of the package substrate 100. Further, the lateral width WD1 of each of the die stack 300 and the redistribution substrate 200 may be greater than a lateral width WD3 of the interconnect package 400.

Each of the semiconductor chips 300A-300C may be one of a system-on-chip (SoC), a microprocessor chip such as a CPU, a GPU, a neural processing unit (NPU), etc., an AI chip, an application-specific integrated circuit (ASIC) chip, an image sensor chip, a power management chip, a memory chip, not being limited thereto. The SoC may include a CPU, a GPU, an NPU or an AI module.

The package substrate 100 may include a substrate core 100C, a lower build-up layer 100L thereabove and an upper build-up layer 100U therebelow. The substrate core 100C may provide structural stability to the semiconductor package 10, and may be formed of an insulation material such as an epoxy resin or ceramic, not being limited thereto. The package substrate 100 may be a printed circuit board or a motherboard of an electronic device or system. Alternatively, the package substrate 100 may be a portion of the PCB or the motherboard of the electronic device or system.

The lower build-up layer 100L and the upper build-up layer 100U may be stacked on a bottom surface and a top surface of the substrate core 100C, respectively, to provide an additional connection and routing space to the semiconductor package 10. The build-up layers 100L and 100U may each include one or more dielectric layers in which a plurality of wiring patterns 100W are formed to be connected to each other or connected to core vias 100V vertically penetrating the package substrate 100. Each wiring pattern in the dielectric layers may include at least one line part and at least one via part connected to each other to form a damascene structure. The line part and via part may be the same as or similar to a line part L and a via part V, respectively, included in the interconnect package 400 that will be described later in reference to FIG. 1B. The wiring patterns 110 may also be referred to as wiring traces.

The wiring patterns 100W and the core vias 100V may each be formed of a conductive material such as copper (Cu), aluminum (Al), tungsten (W), cobalt (Co), ruthenium (Ru), and molybdenum (Mo), not being limited thereto. The dielectric layers may be formed of an organic material such as a photosensitive polymer, for example, photosensitive polyimide, or not being limited thereto. Alternatively or additionally, the dielectric layers may be formed of at least one of silicon oxide (e.g., SiO or SiO₂), silicon nitride (e.g., SiN), silicon oxynitride (e.g., SiON) and silicon carbonitride (e.g., SiCN), not being limited thereto. The dielectric layers have insulation properties so that the wiring patterns 100W may be electrically isolated from each other in the dielectric layers.

Further, a plurality of external terminals 100T such as solder balls or bumps may be formed on a bottom surface of the lower build-up layer 100L that is also a bottom surface of the package substrate 100. The external terminals 100T may connect the semiconductor chips 300A-300C to external circuit elements through various connection structures included in and formed across the package substrate 100 and the redistribution substrate 200 to be further described later.

A plurality of stiffeners 600 may be formed on top surfaces of perimeters of the package substrate 100 to prevent the package substrate 100 from warping that may occur during a packaging process of the semiconductor package 10 or after the semiconductor package 10 is completed. The stiffeners 600 may be made of a metal, ceramic or their compound, not being limited thereto.

The redistribution substrate 200 may include a first redistribution layer 200L and a second redistribution layer 200U connected to each other through a plurality of first through vias 200V isolated from each other through a first molding layer 200M formed of an epoxy resin. The first redistribution layer 200L may be disposed to face the package substrate 100, and the second redistribution layer 200U may be disposed to face the die stack 300 including the semiconductor chips 300A-300C.

The redistribution layers 200L and 200U may each include therein a plurality of wiring traces isolated from each other through one or more vertically-stacked dielectric layers and connected to the first through vias 200V respectively. The wiring traces included in the first redistribution layer 200L may be connected to the core vias 100V in the package substrate 100 through a plurality of lower connection terminals 200T isolated from each other by a first under-fill layer 200F. The first through via 200V as well as the wiring traces in the redistribution layers 200L and 200U may also be formed of a metal such as copper (Cu), aluminum (Al), tungsten (W), cobalt (Co), ruthenium (Ru), and molybdenum (Mo), not being limited thereto.

The wiring traces and the dielectric layers in the redistribution layers 200L and 200U may be similar to or the same as the wiring patterns in the build-up layers 100L and 100U of the package substrate 100 in terms of shape, material and function or role thereof. Thus, duplicate descriptions may be omitted herein. The first under-fill layer 200F may be formed of an epoxy resin, not being limited thereto.

On the second redistribution layer 200U may be seated the die stack 300 including the semiconductor chips 300A-300C which may each be a high-performance chip such as a system-on-chip (SoC) or a memory chip. The semiconductor chips 300A-300C may be connected to the wiring traces in the second redistribution layer 200U though the upper connection terminals 300T isolated from each other by a second under-fill layer 300F which may be formed of the same or similar material forming the first under-fill layer 200F (e.g., epoxy resin).

For example, the semiconductor chips 300A and 300C may be a high bandwidth memory (HBM) and the semiconductor chip 300B may be a system-on-chip (SoC), not being limited thereto. A second molding layer 300M, which may include, for example, an epoxy resin, may be formed at side surfaces of these chips to laterally isolate each chip from the other chips.

The upper connection terminals 300T and the lower connection terminals 200T may also be solder balls or bumps like the external terminals 100T, and may all be formed of a metallic material such as copper (Cu), tin (Sb), lead (Pb), silver (Ag), or their compound, not being limited thereto.

The semiconductor package 10 may also include a plurality of interconnect packages 400 in the redistribution substrate 200 below the second redistribution layer 200U to connect or bridge the semiconductor chips 300A-300C to each other.

For example, one of the interconnect packages 400 may be embedded in the redistribution substrate 200 below a boundary of the adjacent semiconductor chips 300A and 300B in the second molding layer 300M, and may be partially overlapped by each of the two chips at least to reduce a connection length between the two semiconductor chips. Further, the lateral width WD3 of the interconnect package 400 may be smaller than the lateral width WD1 of each of the redistribution substrate 200 and the die stack 300. Thus, the entire lateral width of each of the die stack 300 and the redistribution substrate 200 may not be vertically overlapped by the entire lateral width of the interconnect package 400 in a vertical direction, that is, a D3 direction that intersects the D1 direction and a D2 direction.

Referring to FIGS. 1A and 1B, the interconnect package 400 may include a third redistribution layer 400R and a support layer 400S which is attached to the first redistribution layer 200L of the redistribution substrate 200 through a die attach film (DAF) 400F. The third redistribution layer 400R may include a dielectric layer 400D and a plurality of wiring traces 400W formed therein. The wiring traces 400W may locally connect the two semiconductor chips 300A and 300B to each other, and may also be connected to a voltage source to deliver power to the semiconductor chips 300A and 300B through the second redistribution layer 200U and the upper connection terminals 300T connected thereto.

Referring to FIG. 1B, the dielectric layer 400D of the interconnect package 400 may include a plurality of dielectric layers D1-D4 that are vertically stacked on the support layer 400S. Further, the wiring traces 400W may include one or more power wiring traces W1 and one or more signal wiring traces W2 embedded in the dielectric layers D1-D4. The power wiring traces W1 may include a power line and a ground line for power delivery purposes through the second redistribution layer 200U. The signal wiring traces W2 may connect the two semiconductor chips 300A and 300B to each other. Each of the wiring traces W1 and W2 may include at least one line part L and at least one via part V connected to each other across a plurality of dielectric layer D1-D4 forming the dielectric layer 400D of the interconnect package 400.

In the present embodiment, the dielectric layer 400D includes four dielectric layers D1-D4. However, the disclosure is not limited thereto, and the dielectric layer 400D may include more or less than four dielectric layers D1-D4 according to embodiments. For example, the dielectric layer 400D may be even a single dielectric layer.

Similarly, the other interconnect package 400 may be disposed below a boundary between the adjacent semiconductor chips 300B and 300C in the second molding layer 300M, and may connect the semiconductor chips 300B and 300C to each other through the wiring traces 400W, the wiring traces in the second redistribution layer 200U and the upper connection terminals 300T. Although not shown in the drawings, the semiconductor chips 300A-300C may each include connection pads on bottom surfaces thereof to be connected to the upper connection terminals 300T.

The wiring traces 400W and the dielectric layers 400D in the third redistribution layer 400R may be formed of the same materials forming the wiring traces and the dielectric layers included in the first and second redistribution layers 200L and 200U. Thus, duplicate descriptions thereof may be omitted herein. The support layer 400S supporting the dielectric layers 400D thereabove may be formed of, for example, silicon, glass or ceramic, not being limited thereto.

Moreover, the semiconductor package 10 may also include a plurality of land-side capacitors (LSCs) 500L and die-side capacitors (DSCs) 500D respectively disposed on bottom and top surfaces of the package substrate 100. Each of the LSCs 500L and the DSCs 500D may be a decoupling capacitor that controls impedance and noise applied to the semiconductor chips 300A-300C and other active devices, if any, included in the semiconductor package 10. The LSCs 500L and the DSC 500D may each be implemented by a multilayer ceramic capacitor (MI,CC), a metal-in-metal (MiM) capacitor or a deep trench capacitor (DTC).

Thus, a stable power delivery to the semiconductor chips 300A-300C and the other active devices may be enabled though these decoupling capacitors 500L and 500D.

However, at least one of the semiconductor chips 300A-300C may be an SoC, and this SoC may include a high performance components such as a CPU, a GPU, an NPU or an AI module that consumes a greater amount of power. Thus, additional decoupling capacitors may be required in the semiconductor package 10 including the semiconductor chips 300A-300C.

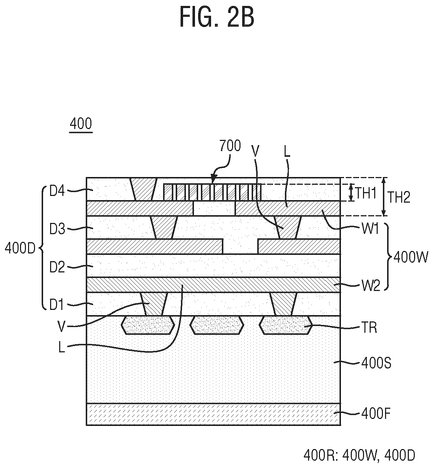

FIG. 2A illustrates a schematic cross-section view of semiconductor package including interconnect packages and decoupling capacitors, according to another embodiment, and FIG. 2B illustrates a schematic cross-section view of an interconnect package included in the semiconductor package shown in FIG. 2A, according to an embodiment.

Referring to FIG. 2A, a semiconductor package 20 may include the same structural elements in the same structural configuration as the semiconductor package 10 shown in FIG. 1A except that the interconnect packages 400 may each include a capacitor 700 in the third redistribution layer 400R. Thus, differences of the semiconductor package 20 from the semiconductor package 10 may be described herebelow while duplicate descriptions thereof may be omitted.

The capacitor 700 may be a capacitor referred to as an integrated stack capacitor (ISC), not being limited thereto, embedded in the interconnect package 400, and may also function as a decoupling capacitor like the DSCs 500D and the LSCs 500L disposed on the package substrate 100 as described in reference to FIG. 1A.

Referring to FIG. 2B, a vertical thickness TH1 of the capacitor 700 may be smaller than a vertical thickness of the third redistribution layer 400R, and may be smaller than even a vertical thickness TH2 of one of the dielectric layers D1-D4 (e.g., D4 as shown in FIG. 2B) of the dielectric layers 400D. Thus, the capacitor 700 may be embedded in one of the dielectric layers D1-D4 such that the vertical thickness TH1 of the capacitor 700 is included in or within the vertical thickness TH2 of a single dielectric layer.

For example, the ISC, which may be the capacitor 700, may take a form of a vertical cylinder array including a plurality of capacitive vias between two or more connection terminals, and have a very low profile, for example, about 2.0 × 2.0 × 2.0 µm, while the DSC 500D or the LSC 500C which may be an MI,CC has a size of hundreds of micrometers (µm), for example, about 1.0 × 0.5 × 0.35 mm for the 0402 MLCC. While a vertical thickness of the ISC in the D3 direction may be about 2.0 micrometer, each of the dielectric layers D1-D4 of the dielectric layer 400D may a vertical thickness in the D3 direction ranging 3.0 to 10.0 micrometers. Further, the ISC may have a high capacitance density similar to that of the MLCC. For example, the ISC may have hundreds of nF/mm² capacitance values, e.g., 1100 nF/mm².

Due to the above-described low profile and high capacitance density, the capacitor 700 may be embedded inside the third redistribution layer 400R at a desired location for the same functional purpose of the DSCs 500D and the LSCs 500L.

For example, the capacitor 700 may be formed in an upper portion of the third redistribution layer 400R which is disposed to be close to the semiconductor chips 300A and 300B. When disposed to be close to the semiconductor chips 300A and 300B, the capacitor 700 may have a better performance in controlling impedance and noise applied to the semiconductor chips 300A and 300B than the DSCs 500D and the LSCs 500L disposed far from the semiconductor chips 300A and 300B. As another example, the capacitor 700 may be formed on an upper portion of the power wiring traces W1 of the wiring traces 400W and connected thereto in the third redistribution layer 400R, and connected to the wiring traces in the second redistribution layer 200U right below the semiconductor chips 300A and 300B.

By placing the capacitor 700 closer to a load, that is, the semiconductor chips 300A and 300B, the length of the entire wiring traces between the capacitor 700 and the load may be reduced to provide a low-impedance path for a high-frequency current, and parasitic inductance may be minimized. Further, a faster and more efficient power delivery to the load may be enabled.

The capacitor 700 in the interconnect package 400 may provide at least an additional impedance and noise control performance to the semiconductor package 20 while the DSCs 500D and the LSCs 500L are disposed on the package substrate 100 for the same purposes. However, depending on the design choice, the semiconductor package 20 may dispense with the DSCs 500D and the LSCs 500L because the capacitor 700 is included in the interconnect package 400 right below the semiconductor chips 300A and 300B.

Moreover, as the semiconductor package 20 may dispense with at least one of the DSCs 500D and the LSCs 500L, an overall size of the semiconductor package 20 can be reduced. For example, while the external terminals 100T, which may be solder balls or bumps, may form a ball grid array (BGA) of the semiconductor package 20, removal of the LSCs 500L that may be formed between the external terminals 100T on the bottom surface of the package substrate 100 as shown in FIG. 2A may reduce constraints on a package design including a ball design for the BGA semiconductor package 20. For example, the external terminals 100T may be formed by smaller-sized solder balls or bumps at a smaller pitch and profile, which helps reduce an overall stack-up height of the semiconductor package 20.

The above embodiment of embedding the capacitor 700 in the interconnect package 400 may also apply to a land grid array (LGA) semiconductor package, that is, the semiconductor package 20 without the external terminals 100T (solder balls or bumps). In this case, elimination of the LSCs 500L from the bottom surface of the package substrate 100 may remove a need of a cavity inside an original equipment manufacturer (OEM) socket to improve a structural integrity with the OEM socket.

In the meantime, the interconnect package 400 including the capacitor 700 may not be limited to the structure as described above and shown in FIG. 2A. According to an embodiment, the interconnect package 400 may include one or more active devices such as transistors therein. For example, FIG. 2B shows that transistors TR such as field-effect transistors may be formed in the support layer 400S, and may be connected to the wiring traces 400W. In this case, the capacitor 700 may also serve to reduce impedance and noise applied to these transistors. Further, the support layer 400S structurally support the third redistribution layer 400R may be differently configured as described below.

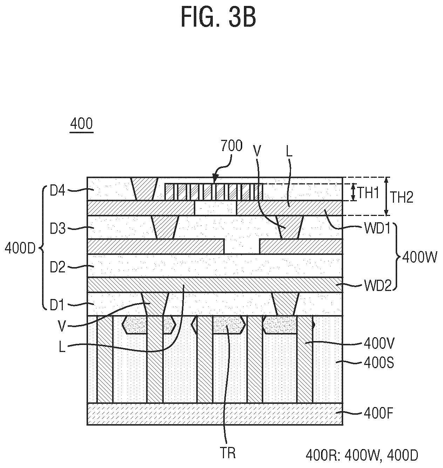

FIG. 3A illustrates a schematic cross-section view of semiconductor package including interconnect packages and decoupling capacitors, according to still another embodiment, and FIG. 3B illustrates a schematic cross-section view of an interconnect package included in the semiconductor package shown in FIG. 3A, according to an embodiment.

Referring to FIGS. 3A and 3B, a semiconductor package 30 may include the same structural elements under the same structural configuration as the semiconductor package 20 except that the interconnect packages 400 may have one or more second through vias 400V formed therein. Thus, differences of the semiconductor package 30 from the semiconductor package 20 may be described herebelow while duplicate descriptions thereof may be omitted.

The second through vias 400V may be formed to penetrate through the support layer 400S and the die attach film 400F to connect the wiring traces 400W in the third redistribution layer 400R to the wiring traces formed in the first redistribution layer 200L. The second through vias 400V may be connected to the capacitor 700 to extend the impedance control function of the capacitor 700 to other circuit elements in the semiconductor package 30 including active devices (transistors TR) that may be embedded in the interconnect package 400 as described above in FIG. 2B. Thus, the second through vias 400V may connect the capacitor to the active devices. The second through vias 400V may be formed of the same or similar metal as the core vias 100V and the first through vias 200V

In the above embodiments, each of the semiconductor packages 20 and 30 is described as including the two interconnect packages 400 to connect the three semiconductor chips 300A-300C, and each of the interconnect packages 400 is described as including one capacitor 700, which may be an ISC, embedded therein. However, the disclosure is not limited thereto. According to embodiments, more or less than three semiconductor chips may be disposed on the redistribution substrate 200 in each of the semiconductor packages 20 and 30, and each of the interconnect packages 400 may include a plurality of capacitors embedded therein for the same or similar purposes described above for the capacitor 700 in the interconnect package 400.

In the above embodiments, one interconnect package, that is, the interconnect package 400, is formed below the boundary of two adjacent semiconductor chips 300A and 300B or 300B and 300C in each of the semiconductor packages 20 and 30. However, one or more additional interconnect packages may be formed below the boundary to provide additional signal routing paths between the two semiconductor chips in the semiconductor package 20 or 30. Further, one or more capacitors such as the capacitor 700 may be formed therein to further reduce impedance and noise applied to the two semiconductor chips, according to embodiments.

In the above embodiments, one redistribution substrate, that is, the redistribution substrate 200 with the interconnect package 400 including the capacitor 700, is formed in each of the semiconductor packages 20 and 30. However, one or more additional redistribution substrates with or without the interconnect package 400 may be formed above, below or at a side of the redistribution substrate 200 in the semiconductor package 20 or 30 to provide at least one additional redistribution path to the semiconductor chips 300A-300C, according to embodiments. For example, one of the semiconductor chips 300A-300C may be connected to another circuit element or semiconductor chip in another semiconductor package or device through the additional redistribution path provided by the additional redistribution substrates in the semiconductor package 20 or 30. Here, the additional redistribution path may be a power delivery path or a signal routing path from or to the semiconductor package 20 or 30.

In the above embodiments, the interconnect packages 400 are formed in the redistribution substrate 200 below the semiconductor chips 300A-300C and above the package substrate 100. However, according to embodiments, at least one of the interconnect packages 400 may be formed above the semiconductor chips 300A-300C with corresponding connection structures therebetween, and the capacitor 700 may also be embedded therein. When the interconnect package 400 is formed above the semiconductor chips 300A-300C, the third redistribution layer 400R may be formed below the support layer 400S so that the capacitor 700 formed on the wiring traces 400W in the third redistribution layer 400R can be disposed close to the semiconductor chips 300A-300C.

Herebelow, a method of manufacturing a semiconductor package including an interconnect package and a decoupling capacitor therein, according to embodiments is described in reference to FIGS. 4 and 5A-5F.

FIG. 4 illustrates a flowchart for a method of manufacturing a semiconductor package including an interconnect package and a decoupling capacitor therein, according to embodiments. FIGS. 5A-5F illustrate intermediate semiconductor packages after respective steps of manufacturing a semiconductor package including an interconnect package and a decoupling capacitor therein based on the flowchart shown in FIG. 4, according to embodiments.

The semiconductor package manufactured in the following method may be the same as or correspond to the semiconductor package 20 shown in FIGS. 2A and 2B, and thus, duplicate descriptions may be omitted and the same reference numerals referring to the structural elements of the semiconductor package 20 are used herebelow.

In step S10, the first redistribution layer 200L may be disposed on a carrier substrate 101, and the interconnect packages 400 and the first through vias 200V may be formed on the first redistribution layer 200L, as shown in FIG. 5A.

The first redistribution layer 200L which may include one or more dielectric layers and a plurality of wiring traces embedded therein may be bonded to the carrier substrate 101 through, for example, adhesive bonding using an epoxy-based adhesive, not being limited thereto. When the first redistribution layer 200L is formed of a plurality of dielectric layers, these dielectric layers may be vertically stacked one after another, and the wiring traces having line parts and via parts may be formed across the dielectric layers and isolated from each other.

The first through vias 200V may be formed through, for example, a first photolithography/masking/etching/deposition operation including electroplating, and connected to the wiring traces in the first redistribution layer 200L, and the interconnect packages 400 may be disposed laterally between the first through vias 200V above the first redistribution layer 200L. Each of the interconnect packages 400 may be disposed laterally between the first through vias 200V at a position above which a boundary of two semiconductor chips to be connected to each other through the interconnect package is to be positioned.

The interconnect packages 400, each of which may include the support layer 400S and the third redistribution layer 400R on the die attach film 400F, may be bonded to the first redistribution layer 200L through, for example, adhesive bonding using an epoxy-based adhesive similar to the bonding operation used for forming the first redistribution layer 200L on the carrier substrate 101. The third redistribution layer 400R may include the dielectric layer 400D and the wiring traces 400W embedded therein. Moreover the third redistribution layer 400R may include the capacitor 700 on an upper portion thereof, for example, an upper portion of the wiring traces 400W in the third redistribution layer 400R.

In step 20, the intermediate semiconductor package obtained in the previous step may be over-molded such that spaces between the first through vias 200V and the interconnect packages 400 are filled in with an epoxy resin, and planarized so that top surfaces of the first molding layer 200M, the first through vias 200V and the interconnect packages 400 may be horizontally aligned or coplanar with each other. See FIG. 5B.

In step 30, the second redistribution layer 200U may be disposed on the intermediate semiconductor package obtained in the previous step through, for example, adhesive bonding using an epoxy-based adhesive, thereby completing the redistribution substrate 200. Further, the upper connection terminals 300T may be formed on the second redistribution layer 200U through, for example, a second photolithography/masking/etching/deposition operation including electroplating, and over-molded by, for example, an epoxy-resin to form the second under-fill layer 300F isolating the upper connection terminals 300T from each other. The upper connection terminals 300T and the second under-fill layer 300F may be planarized such that top surfaces of the upper connection terminals 300T and the second under-fill layer 300F may be horizontally aligned or coplanar with each other. See FIG. 5C

Similar to the first redistribution layer 200L, the second redistribution layer 200U may also include one or more dielectric layers and a plurality of wiring traces embedded therein. The second redistribution layer 200U may be formed such that the wiring traces included therein are respectively connected to the first through vias 200V and the wiring traces 400W of each of the interconnect packages 400. Further, the upper connection terminals 300T may be respectively connected to the wiring traces included in the second redistribution layer 200U.

In step S40, the semiconductor chips 300A-300C may be seated on and connected to the upper connection terminals 300T, respectively, and over-molded using, for example, an epoxy resin so that the second molding layer 300M may be formed between the semiconductor chips 300A-300C for lateral isolation thereof. See FIG. 5D.

The semiconductor chips 300A and 300C may be a high bandwidth memory (HBM) and the semiconductor chip 300B may be a system-on-chip (SoC), not being limited thereto.

In step S50, the carrier substrate 101 may be removed through, for example, mechanical grinding, and the lower connection terminals 200T may be formed on a bottom surface of the second redistribution layer 200L through, for example, soldering such that the wiring traces in the second redistribution layer 200L are respectively connected to the lower connection terminals 200T. See FIG. 5E.

In step S60, the intermediate semiconductor package obtained in the previous step may be attached to the package substrate 100 through the lower connection terminals 200T which may be solder balls or bumps, and the lower connection terminals 200T may be molded by the first under-fill layer 200F to be isolated from each other. The surface mount technology (SMT) may be applied in attaching the intermediate semiconductor package to the package substrate 100 which may include the substrate core 100C, the lower build-up layer 100L and the upper build-up layer 100U. See FIG. 5F.

The lower connection terminals 200T may be positioned above and connected to the core vias 100V included in the package substrate 100 so that the lower connection terminals 200T may be connected to the external terminals 100T formed on the bottom surface of the package substrate 100.

Further, the LSCs 500L and the DSCs 500D may be integrated into the package substrate 100, and the stiffeners 600 are formed on the top surfaces of perimeters of the package substrate 100 to prevent the package substrate 100 from warping that may occur at least during a subsequent packaging process.

FIG. 6 is a schematic diagram illustrating an electronic device including at least one of semiconductor packages shown in FIGS. 2A-2B and/or 3A-3B, according to an embodiment.

Referring to FIG. 6, an electronic device 1000 may include a printed circuit board (PCB) or motherboard 1010 on which a plurality of semiconductor packages 1011-1015 are mounted. The electronic device 1000 may also include a plurality of other components 1020.

The semiconductor package 1011 may include a plurality of chips such as an SoC and memory chips. The SoC may include at least one of a CPU, a GPU, an AI module, a modem, one or more memory units, a power management unit, etc. to control overall operations of the electronic device 1000. The memory chips included in the semiconductor package 1011 may be one or more of a flash memory, a static random access memory (SRAM), a read-only-memory (ROM), etc. The other semiconductor packages 1012-1015 may include dynamic random access memory (DRAM) chips, various other processor chips, communication chips and interface chips, respectively. The communication chips included in the semiconductor package 1014 may be configured to also perform wireless or wire communication functions in association with the SoC. At least one of the semiconductor packages 1011-1015 may be implemented by the semiconductor package 20 or 30 shown in FIGS. 2A and 3A.

The other components 1020 included in the electronic device 100 may include a storage, a camera module, a speaker, a microphone, a display, a battery, etc. The storage may be configured to store user data. The storage may be an embedded multimedia card (eMMC), a solid state drive (SSD), a universal flash storage (UFS) device, etc. The display may be implemented to display data processed by the SoC and/or to receive data through a touchscreen panel of the display.

The foregoing is illustrative of exemplary embodiments and is not to be construed as limiting the disclosure. Although a few exemplary embodiments have been described, those skilled in the art will readily appreciate that many modifications are possible in the above embodiments without materially departing from the disclosure.

## Claims

1. A semiconductor device comprising:
an interconnect package comprising at least one dielectric layer and at least one first wiring trace formed in the at least one dielectric layer, and configured to connect a plurality of semiconductor chips through the at least one first wiring trace,
wherein the interconnect package further comprises a capacitor on the at least one first wiring trace, the capacitor being coupled to the at least one first wiring trace.

2. The semiconductor device of claim 1, wherein the semiconductor chips are disposed above the interconnect package in a first direction.

3. The semiconductor device of claim 2, further comprising a redistribution substrate in which the interconnect package is included, and
wherein the redistribution substrate has a greater lateral width than the interconnect package in a second direction that intersects the first direction.

4. The semiconductor device of claim 2, further comprising a redistribution substrate in which the interconnect package is included,
wherein the semiconductor chips are disposed above the redistribution substrate in the first direction,
wherein the redistribution substrate comprises at least one redistribution layer in which at least one second wiring trace is formed, and
wherein the at least one second wiring trace connects the at least one first wiring trace to the semiconductor chips.

5. The semiconductor device of claim 4, further comprising a package substrate disposed below the redistribution substrate,
wherein the package substrate comprises a plurality of connection structures therein and a plurality of connection terminals on a first surface and a second surfaces thereof, the second surface being opposite to the first surface,
wherein the connection structures are connected to the connection terminals, respectively, and
wherein at least one of the connection terminals is connected to the at least one first wiring trace through the at least one second wiring trace.

6. The semiconductor device of claim 5, further comprising at least one additional capacitor on a first surface or a second surface of the package substrate opposite to the first surface,
wherein the at least one additional capacitor has a greater size than the capacitor in the interconnect package.

7. The semiconductor device of any one of claims 2 to 6, wherein the capacitor is disposed in an upper portion of the interconnect package which is closer to the semiconductor chips than a lower portion of the interconnect package.

8. The semiconductor device of any one of claims 2 to 7, wherein the at least one dielectric layer comprises a plurality of dielectric layers, and
wherein a thickness of the capacitor is smaller than that of one of the dielectric layers in the first direction.

9. The semiconductor device of any one of claims 2 to 8, further comprising:
the semiconductor chips;
a redistribution substrate below the semiconductor chips in the first direction, the redistribution substrate comprising the interconnect package therein; and
a package substrate below the redistribution substrate in the first direction, the package substrate being connected to the redistribution substrate.

10. The semiconductor device of claim 9, wherein the interconnect package further comprises a support layer on which the at least one dielectric layer is disposed,
wherein the support layer comprises at least one of silicon, ceramic and glass, and
wherein at least one transistor is included in the support layer.

11. The semiconductor device of claim 10, wherein the interconnect package further comprises at least one through via formed in the support layer, and
wherein the at least one through via connects the capacitor to the at least one transistor.

12. The semiconductor device of any one of claims 1 to 11, wherein the at least one first wiring trace comprises:
a power wiring trace on which the capacitor is disposed, the power wiring trace being configured to connect at least one of the semiconductor chips to a voltage source; and
a signal wiring trace configured to connect the semiconductor chips.

13. An electronic device comprising:
a die stack comprising at least two semiconductor chips; and
the semiconductor device according claim 1, wherein:
the interconnect package is disposed below the die stack in a first direction and connecting the semiconductor chips; and
the capacitor is disposed inside the interconnect package and connected to at least one of the semiconductor chips, and configured to be connected to a voltage source,
wherein the interconnect package has a smaller width than the die stack in a second direction which intersects the first direction.

14. The electronic device of claim 13, wherein the interconnect package comprises:
a power wiring trace coupled to the capacitor;
a signal wiring trace connecting the semiconductor chips.

15. The electronic device of claim 13 or 14, wherein the interconnect package is disposed below a boundary of the semiconductor chips in the first direction.
